# EUROPEAN PATENT SPECIFICATION

(11) **EP 4 080 698 B1**
(45) Date of publication and mention of the grant of the patent: **13.03.2024**
(21) Application number: 21305532.0
(22) Date of filing: 22.04.2021
(51) Int. Cl.: H01S 5/22, H01S 5/042

(54) **DUAL-CHANNEL BURIED WAVEGUIDE AND METHOD FOR FABRICATING THE SAME**
DOPPELKANALIGER VERSENKTER WELLENLEITER UND VERFAHREN ZUR HERSTELLUNG DAVON
GUIDE D'ONDES ENTERRÉ À DEUX CANAUX ET SON PROCÉDÉ DE FABRICATION

(43) Date of publication of application: 26.10.2022
(73) Proprietor: Nokia Solutions and Networks Oy, 02610 Espoo (FI)
(72) Inventor: Caillaud, Christophe, 94110 Arcueil (FR); Calo, Cosimo, 91400 Orsay (FR)
(74) Representative: Novagraaf Technologies

(56) References cited:
- EP-A2- 0 911 929
- EP-A2- 1 246 329
- US-A1- 2017 207 604

## Description

### TECHNICAL FIELD

Various example embodiments relate to apparatuses having a dual-channel buried waveguide, notably lasers, semiconductor optical amplifiers or modulators or photodiodes. More particularly, various embodiments relate to such apparatuses having improved performances with self-aligned electrical insulation, as well as a simplified method of fabricating such devices with a buried dual channel waveguide.

### BACKGROUND

The general context is the design and fabrication of III-V optoelectronics components (typically lasers and semiconductor optical amplifiers).

Buried structure is a technology for lasers and semiconductor optical amplifiers. It is typically desired to assure simultaneously a good electrical injection in the active waveguide with low current leakage in the surrounding material and a simple and robust fabrication process (so without selective epitaxial regrowth).
EP 1246 329 A2 discloses inverted V-shaped trenches on both sides of a dual-channel buried waveguide DCBH structure.

### SUMMARY

The embodiments of an apparatus and method according to the invention encompass all the features of the independent claims. They are particular instances of such apparatus and method as defined by the independent claims.

A general embodiment relates to an apparatus having at least one integrated dual-channel buried waveguide, as defined by independent claim 1.

The apparatus of the general embodiment presents the following advantages:
- in the dual channel buried waveguide, the current injection area is defined by the width of the channels of the dual channel buried waveguide, which can be very narrow because they are defined in the same lithography step than the stripe S (therefore there is no limitation due to realignment precision). Outside the channel, voids (eventually filled by insulating materials like polymers) prevent any current leakage;
- the current injection is localized without requiring an ion implantation.

The longitudinal axis of the apparatus corresponds to the axis of light propagation.

According to an embodiment, the active semi-conductor layer stack may comprise at least one active gain layer (for example InGaAs for emission around 1550 nm).

According to another embodiment, the active semi-conductor layer stack may be constituted by an active layer sandwiched between optical confinement layers (for example InGaAsP/InGaAs/InGaAsP stack) or may be a multi-quantum well structure sandwiched between optical confinement layers.

These examples of active semi-conductor layer stack are not limitative and can be replaced by any active configuration well known by hose skilled in the art.

The apparatus may further comprise a top-side contact layer of the p-type.

Advantageously, the respective distance W1, W2 separating the central stripe portion from each trench may be between 5 µm and 20 µm.

Advantageously, the widths Wᵢₛₒₗ₁, Wᵢₛₒₗ₂ of each channel may be between 0.5 µm and 5 µm, and the width of central stripe portion may be between 0.1 µm and 10 pm, and in some embodiment said width of the central stripe portion may be between 0.8 µm and 2.5 µm.

Advantageously, the width Wᵢₛₒₗ₁ is equal to the width Wᵢₛₒₗ₂.

According to a first specific embodiment of the general embodiment, the first cladding semi-conductor layer stack may be of the n-type, and the second cladding semi-conductor layer stack may be of the p-type.

The first cladding semi-conductor layer stack according the first specific embodiment may comprise at least one InP-n layer, and the second cladding semi-conductor layer stack may comprise at least one InP-p layer.

According to a second specific embodiment of the general embodiment, the second cladding semi-conductor layer stack (and the semi-conductor layer stack) may comprise regrown layers realized during the same regrowth process.

According to a third specific embodiment of the general embodiment, the semi-conductor layer stack may be made of a semi-insulating semiconductor layer stack.

Advantageously, for each embodiment above mentioned, the semi-conductor layer stack may be indium phosphide doped with at least one of iron and ruthenium indium phosphide.

Advantageously, for each embodiment above mentioned, at least one of the spaces (V1, V2) may be empty or filled with an insulating material.

The insulating material may be selected among BCB polymers, polyimides and spin glass material.

The apparatus according to the general embodiment may be a laser, a semiconductor optical amplifier, a modulator, or a photodiode.

Embodiments further provide a method of fabrication of an apparatus integrating at least one dual-channel buried waveguide, said method comprising:
- providing a first structure comprising a first cladding semi-conductor layer stack of a first conductivity type;
- forming, on said first cladding semi-conductor layer stack, a guiding semi-conductor layer stack comprising at least an area forming an active semi-conductor layer stack;
- etching, along the longitudinal axis of the apparatus, two channels, each channel of the two channels being on a respective side of the area forming a semi-conductor active layer stack and extending through said first cladding semi-conductor layer stack and said guiding semi-conductor layer stack, so as to define a central stripe portion comprising the active semi-conductor layer stack and two lateral zones arranged on each side of the respective lateral edges of the channels which are opposite the central stripe portion;
- performing a regrowth of a second cladding semi-conductor layer stack of a second conductivity type and comprising at least the forming of at least one regrowth layer tobury the stripe and the channels;-
- at the lateral zones, etching of respective vertical trenches through said second cladding semi-conductor layer stack to the level of the guiding semi-conductor layer stack, said vertical trenches being perpendicular to the longitudinal axis of the apparatus;
- selective etching of said guiding semi-conductor layer stack to the lateral edges of the channels which are opposite the central stripe portion, so as to form respectively two spaces, each space being located a respective side of the central stripe portion (S) and having each the shape of an inverted T.

Advantageously, the method may further comprise an additional step of forming a top-side contact layer.

Advantageously, the guiding semi-conductor layer stack may be entirely constituted by an active semi-conductor layer stack similar to the active semi-conductor layer stack. But outside the central stripe, the guiding semi-conductor layer stack may be passive or active.

### BRIEF DESCRIPTION OF THE DRAWINGS

Some examples of embodiments are now described, by way of example only, and with reference to the attached drawings in which:
- FIGs. 1A and 1B schematically represent cross-sectional views of a first embodiment of the apparatus, further comprising a top-side contact layer of the p-type;;FIG. 2 schematically represents a cross-sectional view of a second embodiment of the apparatus, further comprising a p-metal layer with an air bridge to route it above the trenches;
- FIGs. 3 to 5 schematically represent cross-sectional views of the different steps of the method of fabrication of the apparatus according to the embodiments;
- FIG. 6 schematically represents a cross-sectional global view of the third embodiment of the apparatus, where a N contact is deposited inside a trench T1; T2.

The same reference number represents the same element or the same type of element on all drawings, unless stated otherwise.

### DETAILLED DESCRIPTION

Various approaches are known to the skilled person for the manufacture of buried lasers and amplifiers.

For example, a simple approach, which does not require selective epitaxial regrowth, is to bury the active waveguide with P-doped material and then to localize current injection by neutralizing P dopant with H+ implantation in areas surrounding the active waveguide (BRS technology). However, this approach faces several issues:
- ion implanters are very heavy and expensive equipment: thus, this step is often subcontracted (especially by small and medium-sized companies or research teams), which generates additional costs and requires that the wafer temporarily leaves the cleanroom environment, thus increasing the risk of sample contamination;
- very thick photoresists are often needed to protect specific areas from implantation, which can have a detrimental impact on the control of critical dimensions (CDs) in the lithographic steps and increase process complexity;
- critical realignment of the implantation lithography respective to the waveguide is typically required to limit current leakage; despite this, the non-implanted region where the current flows is usually much larger than the active waveguide (typically around 10 µm versus 1-2 µm) due to H+ diffusion and the need to cope with lithography alignement and CD control tolerances;
- ion implantation induces damages in the crystalline structure of semiconductors, possibly leading to premature aging and degradation of the device performances.

Other buried heterostructure manufacturing methods are possible, such as PNBH technology and SIBH technology. However, these technologies typically suffer from a much more complex epitaxial growth with a first selective regrowth and, often, a second P regrowth. Due to the selective regrowth, they are strongly dependent of the geometry of the component. Therefore these approaches which require selective regrowth are typically complex.

Thus, in light of the foregoing, there exists a need to simplify the manufacture of such buried heterostructure apparatuses (using non-selective regrowth) to allow for structures with improved performance and self-aligned electrical insulation.

The figures and the following description, which aim toward remedying the disadvantages identified above, illustrate specific exemplary embodiments of the invention. It will thus be appreciated that those skilled in the art will be able to devise various arrangements that, although not explicitly described or shown herein, embody the principles of the invention and are included within the scope of the invention. Furthermore, any examples described herein are intended to aid in understanding the principles of the invention and are to be construed as being without limitation to such specifically recited examples and conditions. As a result, the invention is not limited to the specific embodiments or examples described below, but by the claims.

In the following description, well-known functions or constructions by the man skilled in the art are not described in detail since they might obscure the invention in unnecessary detail.

In the following description of the figures, schematic representations are non-limiting and serve only for the understanding of the invention.

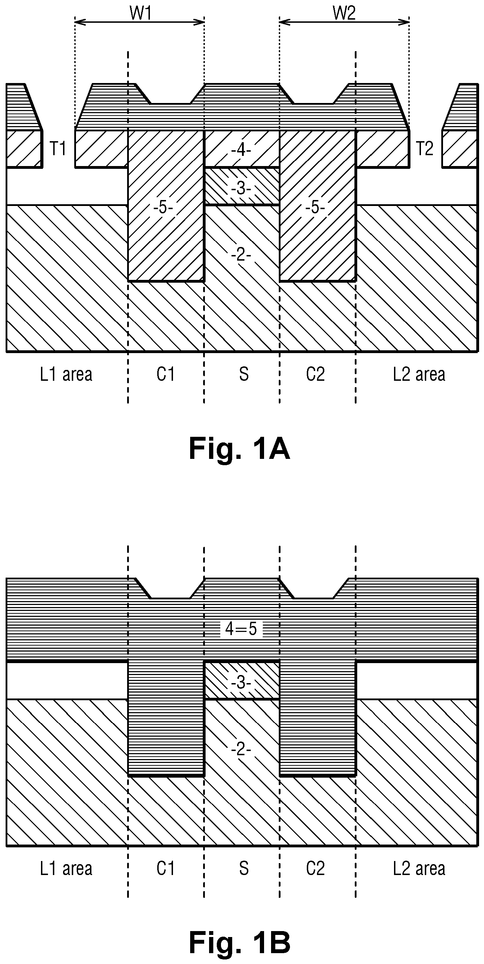

FIG. 1A and 1B shows an embodiment of the apparatus comprising:
- a first cladding semi-conductor layer stack of a first conductivity type,
- an active semi-conductor layer stack 3 for producing optical gain and/or light emission, said active semi-conductor layer stack 3 being formed on said first cladding semi-conductor layer 2, and buried under
- a second cladding semi-conductor layer stack 4 of a second conductivity type, comprising at least one regrowth layer.

In the embodiment shown in figures 1A and 1B, the first cladding semi-conductor layer stack 2 is of the n-type, notably comprising InP-n layers, the active semi-conductor layer stack 3 comprises at least one active gain layer such as e.g. InGaAs, and the second cladding semi-conductor layer stack 4 is of the p-type, notably comprising InP-p layers.

The integrated dual-channel buried waveguide W is formed along the longitudinal axis (corresponding to the axis of light propagation) of the apparatus and comprises at least one central stripe portion S with a dual channel of two channels C1, C2 of widths Wᵢₛₒₗ₁ and Wᵢₛₒₗ₂ respectively (defining the current leakage blocking sections) and being formed along both sides of the stripe S and extending through the first cladding semi-conductor layer stack 2, the active semi-conductor layer stack 3 and the second cladding semi-conductor layer stack 4. The channels C1, C2 are buried in a semi-conductor layer stack 5.

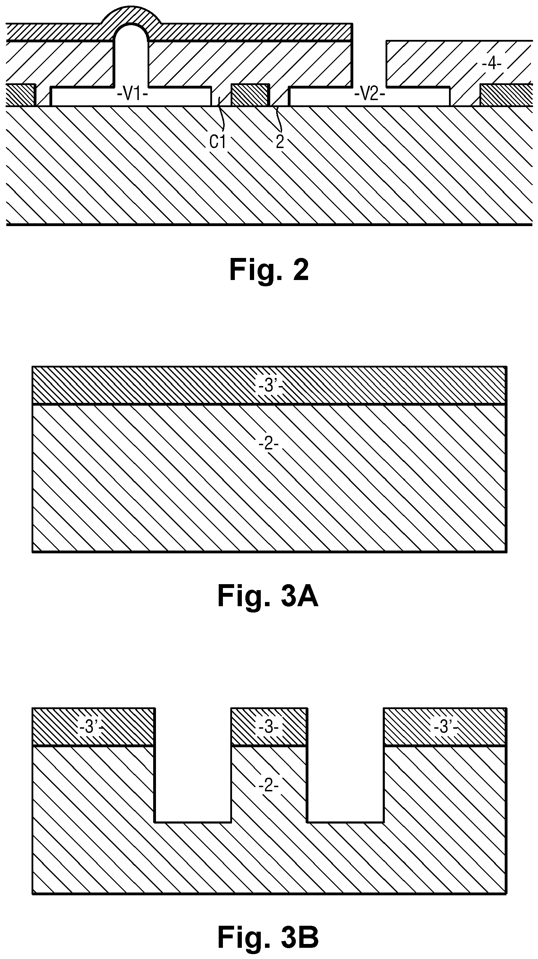

On respective edges of the channels C1, C2 which are opposite the central stripe portion S, there are lateral zones L1, L2 within which there are etched vertical trenches T1, T2 through the second cladding semi-conductor layer stack 4 to the level of the active layer stack 3 where they extend longitudinally through the entire thickness of said active layer stack 3 up to the edges of the channels C1, C2 which are opposite the central stripe portion S, so as to form respectively two spaces V1, V2 (or "void areas") in the lateral zones L1, L2 (see FIG. 2).

The distance W1, W2 between the edge of the stripe S and the edge of the trenches T1, T2, may be comprised between 5 and 20 µm.

In the apparatus having an integrated dual-channel buried waveguide W, the electrical insulation is made by the "void" area (spaces V1, V2 in figure 2) defined in the same lithography than the waveguide definition (i.e. the active semi-conductor layer stack 3), avoiding the need of a critical realignment, as shown by figures 1 and 2. Such an apparatus allows to have a very small current leakage blocking section (Wᵢₛₒₗ₁+Wᵢₛₒₗ₂) as it is defined by lithography. Advantageously, Wᵢₛₒₗ₁, Wᵢₛₒₗ₂ are between 0.5 µm and 5 µm, and the width of central stripe portion S is between 0.1 µm and 10 pm, and in some embodiments between 0.8 µm and 2.5 µm.

For a typical waveguide width of 1-2 µm (width wₛ of the central stripe portion S), the total conduction width (i.e. the cumulative width of the central part of the S-band and of each channel C1 and C2, i.e Wₛ+Wᵢₛₒₗ₁+Wᵢₛₒₗ₂) may be e.g. between 5 and 6 pm, which is much lower than the conductor with of a similar buried heterostructure apparatus realized by ion implantation.

Therefore, in the apparatus of the general embodiment, the active section (or central stripe S) represents from 20% to 50% of the conduction section compared to 10-20% in similar buried heterostructure apparatus realized by H+ implantation. Furthermore, the distances L1, L2 between the waveguide (central stripe S) and the trenches can be large due to the selective etching of the active semi-conductor layer stack 3 (see the method below), and notably comprised between 5 µm and 20 µm.

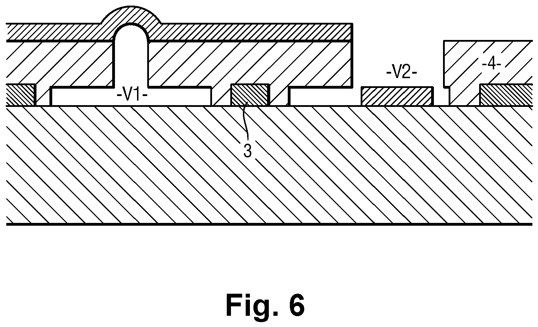

When topside contacts are required for both P and N contact (for flip chip assembly for example, or if a semi insulating substrate is used), this approach of manufacturing a buried heterostructure apparatus according to the general embodiment avoids any additional-etching of the N contact. Furthermore, as topside contacts require mandatorily a P-regrowth etching, in this particular configuration, no additional process step is required (figure 6).

The embodiment shown in Figure 1B differs from that in Figure 1A in that the second semiconductor coating layer stack and the semi-conductor layer stack are fused into a single semi-conductor layer stack.

FIG. 2 shows an apparatus according to a second specific embodiment of the apparatus, which differs from FIG. 1 in that an air bridge is used in this example to route the metal above the trench.

In a curved waveguide, the optical mode is typically dragged to the outer edge of the waveguide. This creates light leakage and losses if the radius of curvature is too small. For example, a classical waveguide with a 520 nm active region (without double channel waveguide, ie equivalent to infinite ∝ Wᵢₛₒₗ gap) is simulated (see table 1 below) . For these simulations Wᵢₛₒₗ₁ = Wᵢₛₒₗ₂.

For a bend with 50 µm radius of curvature, 16.4 cm-1 bending losses are observed in TE polarisation. In the table 1 below, the values of the variations of losses are shown as a function of the values of the gap size Wᵢₛₒ of an apparatus according to the embodiments. Table 1 clearly shows that the optical bending losses are smaller because the spaces V1, V2 prevent mode leakage on the side. The tighter mode confinement in the waveguide enabled by the larger index contrast provided by the proposed method, may be particularly beneficial for reducing the waveguide bending radius and pave the way towards lower footprint devices using buried heterostructure technology.

**Table 1: bending losses as a function of Wisol for a radius of curvature of 50 µm**

| gap Wisol | Alpha_TE (cm⁻¹) | Alpha_TM (cm⁻¹) |
|---|---|---|
| ∝ | 16.4 | ? |
| 0,5 | 2,15828 | 3,30632 |
| 1 | 3,17483 | 6,09951 |
| 1,5 | 5,76015 | 14,4736 |
| 2 | 17,2137 | 54,4236 |

Table 1 shows that the losses decrease when Wᵢₛₒₗ₁ (or Wᵢₛₒₗ₂) is small.

FIGs. 3 to 5 schematically represent cross-sectional views of the different steps of the method of fabrication of the apparatus according to the embodiments.

FIG. 3A notably shows the first structure 10 comprising a first cladding semi-conductor layer stack 2 of a first conductivity type, on which a guiding semi-conductor layer stack 3' is formed. This guiding semi-conductor layer stack 3' comprises at least an area forming an active semi-conductor layer stack 3.

This step is followed by the etching, along the longitudinal axis of the apparatus, of two channels C1, C2 on a respective side of the area forming a semi-conductor active layer stack 3 and extending through the first cladding semi-conductor layer stack 2 and the guiding semi-conductor layer stack 3', so as to define a central stripe portion S comprising the active semi-conductor layer stack 3 and two lateral zones L1, L2 arranged on each side of the respective lateral edges of the channels C1, C2. This step is illustrated in FIG. 3B.

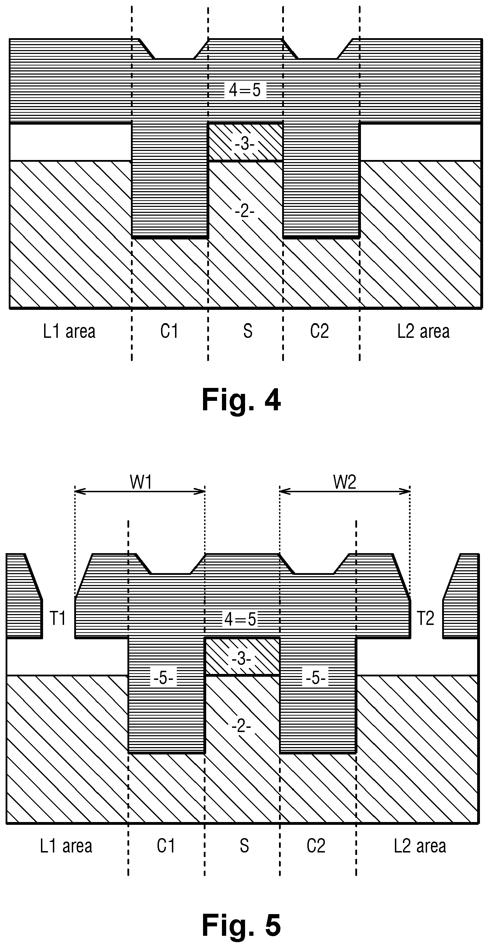

This step is followed by the p-regrowth of a second cladding semi-conductor layer stack 4 to bury the stripe S and the channels C1, C2. This step is illustrated in FIG. 4.

FIG. 5 illustrates in particular the following steps of etching:
- on respective sides of the channels C1, C2 which are opposite the central stripe portion S, etching (notably using dry or wet etching) of vertical trenches T1, T2 through the second cladding semi-conductor layer stack 4 to the level of the guiding semi-conductor layer stack 3';
- selective etching of the guiding semi-conductor layer stack 3'up to the edge of the channel C1, C2, so as to form respectively two empty spaces V1, V2 located on either side of the central stripe portion S and having each the shape of an inverted T, which defines the injection section.

The trenches T1, T2 can be far from the waveguide (or central stripe S) to increase the fabrication tolerances due to the underetching of the active layer 3.

The embodiment of the apparatus obtained with the method of fabrication of the apparatus above described corresponds to the embodiment illustrated in FIG 1B, where the second semiconductor coating layer stack and the semi-conductor layer stack are fused into a single semi-conductor layer stack.

FIG. 6 shows an apparatus according to a specific embodiment of the apparatus of FIG. 3 where a topside contact is used for both P and N contact. Therefore, the contact metal corresponding to the first conductivity type is deposited inside void V2 (avoiding any specific additional etching step to etch down to the semiconductor of the first conductivity type).

## Claims

1. An apparatus having at least one integrated dual-channel buried waveguide (W), said apparatus further comprising:
• a first cladding semi-conductor layer stack (2) of a first conductivity type,
• an active semi-conductor layer stack (3) for producing at least one of optical gain and light emission, said active semi-conductor layer stack (3) being formed on said first cladding semi-conductor layer (2) and buried under
• a second cladding semi-conductor layer stack (4) of a second conductivity type, comprising at least one regrowth layer,
- wherein said at least one integrated dual-channel buried waveguide (W) is formed along a longitudinal axis of the apparatus corresponding to an axis of light propagation and comprises at least one central stripe portion (S) having a width, said central stripe portion having a dual channel of two channels (C1, C2) of widths Wᵢₛₒₗ₁ , Wᵢₛₒₗ₂ respectively, each channel of the two channels (C1, C2) being formed along a respective side of said central stripe portion (S) and extending through said first cladding semi-conductor layer stack (2), said active semi-conductor layer stack (3), said second cladding semi-conductor layer stack (4), and said channels (C1, C2) being buried in a semi-conductor layer stack (5), and
- wherein, on respective edges of the channels (C1, C2) which are opposite the central stripe portion (S), there are lateral zones (L1, L2) within which there are provided respective vertical trenches (T1, T2) perpendicular to the longitudinal axis of the apparatus and crossing through said semi-conductor layer stack (5), said second cladding semi-conductor layer stack (4) to the level of said active semi-conductor layer stack (3),
**characterized in that** said vertical trenches (T1, T2) extend longitudinally through the entire thickness of said active layer stack (3) and laterally up to the edges of the channels (C1, C2) which are opposite the central stripe portion (S), so as to form a space (V1, V2) located in the respective lateral zones (L1, L2), each space (V1, V2) having the shape of an inverted T, as seen in a lateral cross section.

2. The apparatus according to claim 1, wherein the respective distances (W1, W2) separating the central stripe portion (S) from each trench (T1, T2) are between 5 µm and 20 µm.

3. The apparatus according to any of claims 1 or 2 wherein the widths Wᵢₛₒₗ₁ Wᵢₛₒₗ₂ of each channel (C1, C2) are between 0.5 µm and 5 µm, and the width of central stripe portion (S) is between 0.1 µm and 10 µm.

4. The apparatus according to claim 1 to 3, wherein the width of central stripe portion (S) is between 0.8 µm and 2.5 µm.

5. The apparatus according to any of claims 1 to 4, wherein the first cladding semi-conductor layer stack (2) is of the n-type, and the second cladding semi-conductor layer stack (4) is of the p-type.

6. The apparatus according to claim 4, wherein the first cladding semi-conductor layer stack (2) comprises at least one InP-n layer, and the second cladding semi-conductor layer stack (4) comprises at least one InP-p layer.

7. The apparatus according to any of claims 1 to 6, wherein said semi-conductor layer stack (5) is made of a semi-insulating semiconductor layer stack.

8. The apparatus according to claim 7, wherein said semi-conductor layer stack (5) is indium phosphide doped with at least one of iron and ruthenium indium phosphide.

9. The apparatus according to any of claims 1 to 8, wherein at least one of the spaces (V1, V2) is empty.

10. The apparatus according to any of claims 1 to 8, wherein at least one of the spaces (V1, V2) is filled with an insulating material.

11. The apparatus according to any of claims 1 to 10, being a laser or a semiconductor optical amplifier or modulator or a photodiode.

12. A method of fabrication of an apparatus integrating at least one dual-channel buried waveguide (W), said method comprising:
- providing a first structure comprising a first cladding semi-conductor layer stack (2) of a first conductivity type;
- forming, on said first cladding semi-conductor layer stack (2), a guiding semi-conductor layer stack (3') comprising at least an area forming an active semi-conductor layer stack (3);
- etching, along the longitudinal axis of the apparatus, two channels (C1, C2) each channel (C1, C2) of the two channels being on a respective side of the area forming a semi-conductor active layer stack (3) and extending through said first cladding semi-conductor layer stack (2)and said guiding semi-conductor layer stack (3') , so as to define a central stripe portion (S) comprising the active semi-conductor layer stack (3) and two lateral zones (L1, L2) arranged on each side of the respective lateral edges of the channels (C1, C2) which are opposite the central stripe portion (S);
- performing regrowth of a second cladding semi-conductor layer stack (4) of a second conductivity type and comprising at least the forming of at least one regrowth layer to bury the stripe (S) and the channels (C1, C2);
- at the lateral zones (L1, L2), etching of respective vertical trenches (T1, T2) through said second cladding semi-conductor layer stack (4) to the level of the active layer (3), said vertical trenches (T1, T2) being perpendicular to the longitudinal axis of the apparatus;
- selective etching of said guiding semi-conductor layer stack (3') to the lateral edges of the channels (C1, C2) which are opposite the central stripe portion (S), so as to form respectively two spaces (V1, V2), each space (V1, V2) located on a respective side of the central stripe portion (S) and having each the shape of an inverted T.

13. The method according to claim 12, wherein said guiding semi-conductor layer stack (3') is entirely constituted by an active semi-conductor layer stack similar to the active semi-conductor layer stack (3).

## Patentansprüche

1. Vorrichtung mit mindestens einem integrierten zweikanaligen versenkten Wellenleiter (W), wobei die Vorrichtung ferner Folgendes umfasst:
• einen ersten Mantelhalbleiterschichtstapel (2) eines ersten Leitfähigkeitstyps,
• einen aktiven Halbleiterschichtstapel (3) zum Produzieren von mindestens einem einer optischen Verstärkung und einer Lichtemission, wobei der aktive Halbleiterschichtstapel (3) auf der ersten Mantelhalbleiterschicht (2) gebildet und unter Folgendem versenkt ist
• einem zweiten Mantelhalbleiterschichtstapel (4) eines ersten Leitfähigkeitstyps, der mindestens eine Neuaufbauschicht umfasst,
- wobei der mindestens eine integrierte zweikanalige versenkte Wellenleiter (W) entlang einer Längsachse der Vorrichtung gebildet ist, die einer Achse der Lichtausbreitung entspricht und mindestens einen zentralen Streifenabschnitt (S) mit einer Breite umfasst, wobei der zentrale Streifenabschnitt einen doppelten Kanal aus zwei Kanälen (C1, C2) mit einer Breite Wᵢₛₒ₁₁ bzw. Wᵢₛₒ₁₂ aufweist, wobei jeder Kanal der zwei Kanäle (C1, C2) entlang einer jeweiligen Seite des zentralen Streifenabschnitts (S) gebildet ist und sich durch den ersten Mantelhalbleiterschichtstapel (2), den aktiven Halbleiterschichtstapel (3), den zweiten Mantelhalbleiterschichtstapel (4) erstreckt und wobei die Kanäle (C1, C2) in einem Halbleiterschichtstapel (5) versenkt sind, und
- wobei an jeweiligen Kanten der Kanäle (C1, C2), die dem zentralen Streifenabschnitt (S) gegenüberliegen, Seitenzonen (L1, L2) vorhanden sind, innerhalb derer jeweilige vertikale Gräben (T1, T2) bereitgestellt sind, die senkrecht zur Längsachse der Vorrichtung verlaufen und den Halbleiterschichtstapel (5), den zweiten Mantelhalbleiterschichtstapel (4) zur Ebene des aktiven Halbleiterschichtstapels (3) durchqueren, **dadurch gekennzeichnet, dass** sich die vertikalen Gräben (T1, T2) längs durch die gesamte Dicke des aktiven Schichtstapels (3) und seitlich bis zu den Kanten der Kanäle (C1, C2) erstrecken, die dem zentralen Streifenabschnitt (S) gegenüberliegen, um einen Raum (V1, V2) zu bilden, der sich in den jeweiligen Seitenzonen (L1, L2) befindet, wobei jeder Raum (V1, V2) die Form eines umgedrehten T aufweist, wie in einem seitlichen Querschnitt gesehen.

2. Vorrichtung nach Anspruch 1, wobei die jeweiligen Abstände (W1, W2), die den zentralen Streifenabschnitt (S) von jedem Graben (T1, T2) trennen, zwischen 5 µm und 20 µm betragen.

3. Vorrichtung nach einem der Ansprüche 1 oder 2, wobei die Breite Wᵢₛₒ₁₁ Wᵢₛₒ₁₂ jedes Kanals (C1, C2) zwischen 0,5 µm und 5 µm beträgt und die Breite des zentralen Streifenabschnitts (S) zwischen 0,1 µm und 10 µm beträgt.

4. Vorrichtung nach einem der Ansprüche 1 bis 3, wobei die Breite des zentralen Streifenabschnitts (S) zwischen 0,8 µm und 2,5 µm beträgt.

5. Vorrichtung nach einem der Ansprüche 1 bis 4, wobei der erste Mantelhalbleiterschichtstapel (2) vom n-Typ ist, und der zweite Mantelhalbleiterschichtstapel (4) vom p-Typ ist.

6. Vorrichtung nach Anspruch 4, wobei der erste Mantelhalbleiterschichtstapel (2) mindestens eine InP-n-Schicht umfasst und der zweite Mantelhalbleiterschichtstapel (4) mindestens eine InP-p-Schicht umfasst.

7. Vorrichtung nach einem der Ansprüche 1 bis 6, wobei der Halbleiterschichtstapel (5) aus einem halbisolierenden Halbleiterschichtstapel besteht.

8. Vorrichtung nach Anspruch 7, wobei der Halbleiterschichtstapel (5) mit mindestens einem von Eisen- und Ruthenium-Indiumphosphid indiumphosphiddotiert ist.

9. Vorrichtung nach einem der Ansprüche 1 bis 8, wobei mindestens einer der Räume (V1, V2) leer ist.

10. Vorrichtung nach einem der Ansprüche 1 bis 8, wobei mindestens einer der Räume (V1, V2) mit einem Isoliermaterial gefüllt ist.

11. Vorrichtung nach einem der Ansprüche 1 bis 10, bei der es sich um einen optischen Laser- oder Halbleiterverstärker oder einen Modulator oder eine Fotodiode handelt.

12. Verfahren zur Herstellung einer Vorrichtung, die mindestens einen zweikanaligen versenkten Wellenleiter (W) integriert, wobei das Verfahren Folgendes umfasst:
- Bereitstellen einer ersten Struktur, die einen ersten Mantelhalbleiterschichtstapel (2) eines ersten Leitfähigkeitstyps umfasst;
- Bilden eines führenden Halbleiterschichtstapels (3'), der mindestens einen Bereich umfasst, der einen aktiven Halbleiterschichtstapel (3) bildet, auf dem ersten Mantelhalbleiterschichtstapel (2);
- Ätzen von zwei Kanälen (C1, C2) entlang der Längsachse der Vorrichtung, wobei jeder Kanal (C1, C2) der zwei Kanäle auf einer jeweiligen Seite des Bereichs liegt, der einen aktiven Halbleiterschichtstapel (3) bildet, und sich durch den ersten Mantelhalbleiterschichtstapel (2) und den führenden Halbleiterschichtstapel (3') erstreckt, um einen zentralen Streifenabschnitt (S) zu definieren, der den aktiven Halbleiterschichtstapel (3) und zwei Seitenzonen (L1, L2) definiert, die auf jeder Seite der jeweiligen Seitenkanten der Kanäle (C1, C2) angeordnet sind, die dem zentralen Streifenabschnitt (S) gegenüberliegen;
- Durchführen eines Neuaufbaus eines zweiten Mantelhalbleiterschichtstapels (4) eines zweiten Leitfähigkeitstyps, was mindestens das Bilden von mindestens einer Neuaufbauschicht zum Versenken des Streifens (S) und der Kanäle (C1, C2) umfasst;
- an den Seitenzonen (L1, L2) Ätzen von jeweiligen vertikalen Gräben (T1, T2) durch den zweiten Mantelhalbleiterschichtstapel (4) zur Ebene der aktiven Schicht (3), wobei die vertikalen Gräben (T1, T2) senkrecht zur Längsachse der Vorrichtung verlaufen;
- selektives Ätzen des führenden Halbleiterschichtstapels (3') zu den Seitenkanten der Kanäle (C1, C2), die dem zentralen Streifenabschnitt (S) gegenüberliegen, um jeweils zwei Räume (V1, V2) zu bilden, wobei sich jeder Raum (V1, V2) auf einer jeweiligen Seite des zentralen Streifenabschnitts (S) befindet und jeweils die Form eines umgedrehten T aufweist.

13. Verfahren nach Anspruch 12, wobei der führende Halbleiterschichtstapel (3') vollständig durch einen aktiven Halbleiterschichtstapel konstituiert ist, der dem aktiven Halbleiterschichtstapel (3) ähnlich ist.

## Revendications

1. Appareil ayant au moins un guide d'ondes enfoui à double canal (W) intégré, ledit appareil comprenant en outre :
• une pile de première couche semi-conductrice de gaine (2) d'un premier type de conductivité,
• une pile de couche semi-conductrice active (3) pour produire au moins un parmi un gain optique et une émission de lumière, ladite pile de couche semi-conductrice active (3) étant formée sur ladite première couche semi-conductrice de gaine (2) et enfouie sous
• une pile de deuxième couche semi-conductrice de gaine (4) d'un deuxième type de conductivité comprenant au moins une couche de régénération,
- dans lequel ledit au moins un guide d'ondes enfoui à double canal (W) intégré est formé le long d'un axe longitudinal de l'appareil correspondant à un axe de propagation de la lumière, et comprend au moins une partie de bande centrale (S) ayant une largeur, ladite partie de bande centrale ayant un canal double en deux canaux (C1, C2) de largeurs Wᵢₛₒ₁₁ et W_{iSO12} respectivement, chaque canal des deux canaux (C1, C2) étant formé le long d'un côté respectif de ladite partie de bande centrale (S) et s'étendant à travers ladite première couche semi-conductrice de gaine (2), ladite pile de couche semi-conductrice active (3), ladite pile de deuxième couche semi-conductrice de gaine (4), et lesdits canaux (C1, C2) étant enfouis dans une pile de couche semi-conductrice (5), et
- dans lequel, sur des bords respectifs des canaux (C1, C2) qui sont opposés à la partie de bande centrale (S), il y a des zones latérales (L1, L2) dans lesquelles sont prévues des tranchées (T1, T2) verticales respectives perpendiculaires à l'axe longitudinal de l'appareil et traversant, à travers ladite pile de couche semi-conductrice (5), ladite pile de deuxième couche semi-conductrice de gaine (4) jusqu'au niveau de ladite pile de couche semi-conductrice active (3),
**caractérisé en ce que** lesdites tranchées (T1, T2) verticales s'étendent longitudinalement à travers toute l'épaisseur de ladite pile de couche active (3) et latéralement jusqu'aux bords des canaux (C1, C2) qui sont opposés à la partie de bande centrale (S), de manière à former un espace (V1, V2) situé dans les zones latérales (L1, L2) respectives, chaque espace (V1, V2) ayant la forme d'un T inversé, vu dans une section transversale latérale.

2. Appareil selon la revendication 1, dans lequel les distances (W1, W2) respectives séparant la partie de bande centrale (S) de chaque tranchée (T1, T2) sont entre 5 um et 20 µm.

3. Appareil selon l'une des revendications 1 ou 2 dans lequel les largeurs Wᵢₛₒ₁₁ W_{iSO12} de chaque canal (C1, C2) sont entre 0,5 um et 5 um, et la largeur de la partie de bande centrale (S) est entre 0,1 um et 10 um.

4. Appareil selon la revendication 1 à 3, dans lequel la largeur de la partie de bande centrale (S) est entre 0,8 um et 2,5 µm.

5. Appareil selon l'une des revendications 1 à 4, dans lequel la pile de première couche semi-conductrice de gaine (2) est de type n, et la pile de deuxième couche semi-conductrice de gaine (4) est de type p.

6. Appareil selon la revendication 4, dans lequel la pile de première couche semi-conductrice de gaine (2) comprend au moins une couche InP-n, et la pile de deuxième couche semi-conductrice de gaine (4) comprend au moins une couche InP-p.

7. Appareil selon l'une des revendications 1 à 6, dans lequel ladite pile de couche semi-conductrice (5) est réalisée en une pile de couche semi-conductrice semi-isolante.

8. Appareil selon la revendication 7, dans lequel ladite pile de couche semi-conductrice (5) est du phosphure d'indium dopé avec au moins un parmi le phosphure d'indium de fer et le phosphure d'indium de ruthénium.

9. Appareil selon l'une des revendications 1 à 8, dans lequel au moins un des espaces (V1, V2) est vide.

10. Appareil selon l'une des revendications 1 à 8, dans lequel au moins un des espaces (V1, V2) est rempli d'un matériau isolant.

11. Appareil selon l'une des revendications 1 à 10, qui est un laser ou un amplificateur ou modulateur optique à semiconducteur ou une photodiode.

12. Procédé de fabrication d'un appareil intégrant au moins un guide d'ondes enfoui à double canal (W), ledit procédé comprenant :
- la fourniture d'une première structure comprenant une pile de première couche semi-conductrice de gaine (2) d'un premier type de conductivité ;
- la formation, sur ladite pile de première couche semi-conductrice de gaine (2), d'une pile de couche semi-conductrice de guidage (3') comprenant au moins une région formant une pile de couche semi-conductrice active (3) ;
- la gravure de deux canaux (C1, C2) le long de l'axe longitudinal de l'appareil, chaque canal (C1, C2) des deux canaux se trouvant sur un côté respectif de la région formant une pile de couche semi-conductrice active (3) et s'étendant à travers ladite pile de première couche semi-conductrice de gaine (2) et ladite pile de couche semi-conductrice de guidage (3'), de sorte à définir une partie de bande centrale (S) comprenant la pile de couche semi-conductrice active (3) et deux zones latérales (L1, L2) agencées de chaque côté des bords latéraux respectifs des canaux (C1, C2) qui sont opposés à la partie de bande centrale (S) ;
- la réalisation d'une régénération d'une pile de deuxième couche semi-conductrice de gaine (4) d'un deuxième type de conductivité et comprenant au moins la formation d'au moins une couche de régénération pour enfouir les bandes (S) et les canaux (C1, C2) ;
- au niveau des zones latérales (L1, L2), la gravure de tranchées (T1, T2) verticales respectives à travers ladite pile de deuxième couche semi-conductrice de gaine (4) jusqu'au niveau de la couche active (3), lesdites tranchées (T1, T2) verticales étant perpendiculaires à l'axe longitudinal de l'appareil ;
- la gravure sélective de ladite pile de couche semi-conductrice de guidage (3') dans les bords latéraux des canaux (C1, C2) qui sont opposés à la partie de bande centrale (S), de sorte à former respectivement deux espaces (V1, V2), chaque espace (V1, V2) étant situé sur un côté respectif de la partie de bande centrale (S) et ayant chacun la forme d'un T inversé.

13. Procédé selon la revendication 12, dans lequel ladite pile de couche semi-conductrice de guidage (3') est entièrement constituée d'une pile de couche semi-conductrice active similaire à la pile de couche semi-conductrice active (3).
